# EUROPEAN PATENT APPLICATION

(11) **EP 2 330 490 A2**
(43) Date of publication of application: **08.06.2011**
(21) Application number: 09813197.2
(22) Date of filing: 13.07.2009
(51) Int. Cl.: G06F 3/041, G02F 1/133

(54) **DISPLAY APPARATUS, MOBILE DEVICE COMPRISING SAME, AND DISPLAY CONTROL METHOD**

(30) Priority: 09.09.2008 KR 20080088742; 29.05.2009 KR 20090047775
(71) Applicant: Neoviewkolon Co., Ltd., Chungcheongnam-Do 350-883 (KR)
(72) Inventor: PARK, Il-Ho, Chungcheongnam-Do 350-752 (KR); GYOUNG, Chung-Hyoun, Gyeonggi-do 469-842 (KR); KIM, Young-Eun, Seoul 133-846 (KR); KIM, Tae-Su, Busan 613-804 (KR); YM, Woo-Bin, Chungcheongnam-Do 350-751 (KR)
(74) Representative: Beck & Rössig European Patent Attorneys
(86) International application number: PCT/KR2009/003822
(87) International publication number: WO 2010/030075

(57) **Abstract**

Disclosed is a display device which obviates the need for a space to mount an additional sub display, so that a product is made slim and compact. The display device includes an LCD panel or e-paper for displaying main information, a TOLED panel formed on the LCD panel or e-paper and displaying sub information, a touch panel formed on the TOLED panel, and a controller electrically connected to the LCD panel or e-paper, the TOLED panel and the touch panel, in which the controller applies driving voltage to the LCD panel or e-paper so that main information is displayed through the LCD panel or e-paper when an electrical signal of the touch panel is sensed, and applies driving voltage to the TOLED panel so that sub information is displayed through the TOLED panel when the LCD panel or e-paper is off.

## Description

### Technical Field

The present invention relates to a display device, and more particularly to a display device for displaying main information and sub information using a liquid crystal display (LCD) panel or e-paper, and a transparent organic light emitting diode (TOLED) panel, and to a mobile device including the same and to a display control method.

### Background Art

Display devices which are applied to mobile communication terminals such as mobile phones to show various types of information on a screen have been recently developed to be slimmer, lighter and smaller to be able to carry with more ease, by using the core technology of the information communication era.

Typical display devices for use in mobile communication terminals such as mobile phones are configured such that a touch panel is assembled on a single display device such as an LCD, an OLED or e-paper, and an additional sub display is mounted to display simple sub information such as the residual battery capacity, the time, date, user name and so on. In this case, an additional space is required to mount such a sub display, imposing considerable structural limitations on the display device.

Hence, in the case where the conventional display devices are applied to mobile communication terminals such as mobile phones, the total thickness and size of the mobile communication terminal are increased, undesirably making it impossible to achieve slimness and compactness.

### Disclosure

### Technical Problem

Accordingly, the present invention has been made keeping in mind the problems encountered in the related art and the present invention is intended to provide a display device, to which a sub display structure using a TOLED is applied thus obviating the need for a space to mount an additional sub display, so that a product is made slim and compact.

Also the present invention is intended to provide a mobile device including the display device.

Also the present invention is intended to provide a method of controlling the display device.

### Technical Solution

An aspect of the present invention provides a display device, including a main display unit for displaying main information, a sub display unit which is formed on the main display unit and which displays sub information, a touch panel formed on the sub display unit, and a controller which is electrically connected to the main display unit, the sub display unit and the touch panel and which applies driving voltage to the main display unit when an electrical signal of the touch panel is sensed and applies driving voltage to the sub display unit when the main display unit is off.

In this aspect, the main display unit may include any one selected from among an OLED panel, an LCD panel, and e-paper.

In this aspect, the sub display unit may include an OLED panel, and the OLED panel may include a TOLED panel.

As such, the TOLED panel may include a substrate, a first electrode formed on the substrate, an organic layer formed on the first electrode, a second electrode formed on the organic layer, and a transparent layer formed at either one or both of a position between the organic layer and the second electrode and a position on an upper surface of the second electrode and including any one selected from among an oxide, a nitride, a salt, and mixtures thereof

The oxide may include any one selected from the group consisting of MoO₃, ITO, IZO, IO, ZnO, TO, TiO₂, SiO₂, WO₃, Al₂O₃, Cr₂O₃, TeO₂, and SrO₂.

The nitride may include any one selected from the group consisting of SiN and AlN.

The salt may include any one selected from the group consisting of Cs₂CO₃, LiCO₃, KCO₃, NaCO₃, LiF, CsF, and ZnSe.

The transparent layer may have a thickness ranging from 0.1 nm to less than 100 nm.

The organic layer may include an electron transporting layer formed by doping any one selected from the group consisting of a metal having low work function and a compound thereof, in order to facilitate the injection of electrons from the second electrode.

As such, the metal having low work function may include any one selected from the group consisting of Cs, Li, Na, K, and Ca.

Furthermore, the compound thereof may include any one selected from the group consisting ofLi-Al, LiF, CsF, and Cs₂CO₃.

The TOLED panel may exhibit a transmittance of 70 ~ 99% depending on the wavelength (nm).

Another aspect of the present invention provides a mobile device, which is exemplified by a portable media player (PMP) or a mobile communication terminal such as a mobile phone and which includes the display device according to the aspect of the present invention.

A further aspect of the present invention provides a display control method, including sensing an electrical signal of a touch panel with a controller, applying driving voltage to a main display unit so that main information is displayed through the main display unit when the electrical signal of the touch panel is sensed, sensing whether the main display unit is on/off with the controller, and applying driving voltage to a sub display unit so that sub information is displayed through the sub display unit when the main display unit is off.

### Advantageous Effects

As described hereinbefore, the present invention provides a display device, a mobile device including the same and a display control method. According to the present invention, a TOLED panel for displaying sub information is applied on an LCD panel or e-paper for displaying main information, thus obviating the need for a space to mount an additional sub display, so that a product is made slim and compact.

Furthermore, the TOLED panel is configured such that a transparent layer including any one selected from among an oxide, a nitride, a salt and mixtures thereof is formed at either one or both of a position between an organic layer and a second electrode (cathode) and a position on the upper surface of the second electrode, thereby achieving double-sided light emission and increasing transmittance.

Also, because the transparent layer is formed of any one selected from among an oxide, a nitride, a salt and mixtures thereof the internal resistance of the second electrode can be prevented from increasing, thus improving the electrical performance of products.

### Description of Drawings

The features and advantages of the present invention will be more clearly understood from the following detailed description taken in conjunction with the accompanying drawings, in which:
FIG. 1 is an exploded perspective view showing main components of a display device according to an embodiment of the present invention;
FIG. 2 is a block diagram showing the configuration of the display device according to the embodiment ofthe present invention;
FIG. 3 is an exemplary view showing the display of main information using an LCD panel of the display device;
FIG. 4 is an exemplary view showing the display of sub information using a TOLED panel of the display device;
FIG. 5 is a flowchart showing a process of controlling the display device according to the present invention which is for displaying main information and sub information;
FIG. 6 is a cross-sectional view showing the configuration of the TOLED panel of the display device according to the present invention;
FIG. 7 is a graph showing transmittance which depends on the transparent layer of the TOLED panel;
FIG. 8 is a graph showing luminance which depends on the transparent layer of the TOLED panel;
FIG. 9 is a graph showing transmittance when the transparent layer of the TOLED panel is formed of an oxide, a salt, or a mixture thereof; and
FIG. 10 is a flowchart showing a process of manufacturing the TOLED of the display device according to the present invention.

### Best Mode

Hereinafter, a detailed description will be given of a display device, a mobile device including the same and a display control method according to embodiments of the present invention with reference to the accompanying drawings. Throughout the drawings, the same reference numerals refer to the same or similar elements, and redundant descriptions are omitted. Also in the description, in the case where known techniques pertaining to the present invention are regarded as unnecessary because they would make the characteristics of the invention unclear and also for the sake of description, the detailed descriptions thereof may be omitted.

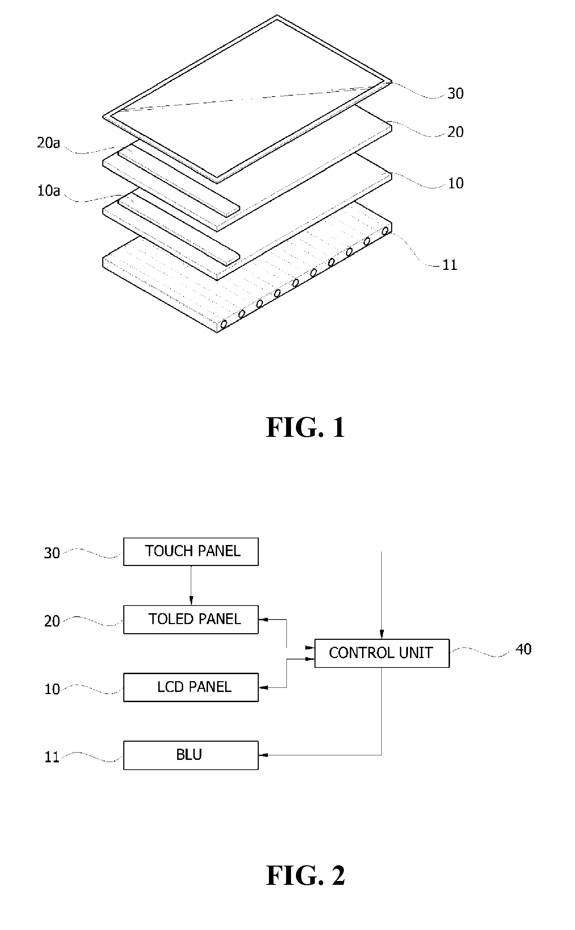

FIG. 1 is an exploded perspective view showing main components of a display device according to an embodiment ofthe present invention, and FIG. 2 is a block diagram showing the configuration of the display device according to the embodiment of the present invention.

As shown in FIGS. 1 and 2, the display device according to the embodiment of the present invention includes an LCD panel 10, an OLED panel 20, a touch panel 30 and a controller 40.

Light emitted from a backlight unit (BLU) 11 provided on a lower surface of the LCD panel 10 passes through the LCD panel 10 using dielectric anisotropy in which a direction of an array of liquid crystals varies depending on voltage applied from the outside, so that letters, numbers or icons are displayed. Examples of the BLU 11 include a cold cathode fluorescent lamp (CCFL), an external electrode fluorescent lamp (EEFL), a light emitting diode (LED), a flat fluorescent lamp (FFL), etc. The LCD panel 10 may be understood by the known art, and a detailed description thereof is omitted.

Provided on the LCD panel 10 is a driving IC 10a connected to the touch panel 30 and the controller 40, which will be described later.

The LCD panel 10 is a main display unit (hereinafter, represented by the reference numeral "10") for displaying main information. For example, in the case where the LCD panel is applied to a mobile device including a PMP or a mobile communication terminal such as a mobile phone, it may display letters, numbers, icons or video images at higher resolution compared to the TOLED panel 20 which will be described later.

In the present embodiment, the main display unit is exemplified by the LCD panel 10, but the present invention is not limited thereto, and the main display unit may include an OLED panel or e-paper, in addition to the LCD panel.

The OLED panel 20 utilizes a self light emission manner in which electrons and holes (which are particles oppositely charged to the electrons) are injected from a cathode and an anode, respectively, and recombine with each other in an organic layer thus emitting light. The OLED panel 20 may be understood by the known art, and a detailed description thereof is omitted.

The OLED panel 20 is disposed on the upper surface of the LCD panel 10.

In the present embodiment, the OLED panel 20 includes a TOLED panel (hereinafter, represented by the reference numeral "20").

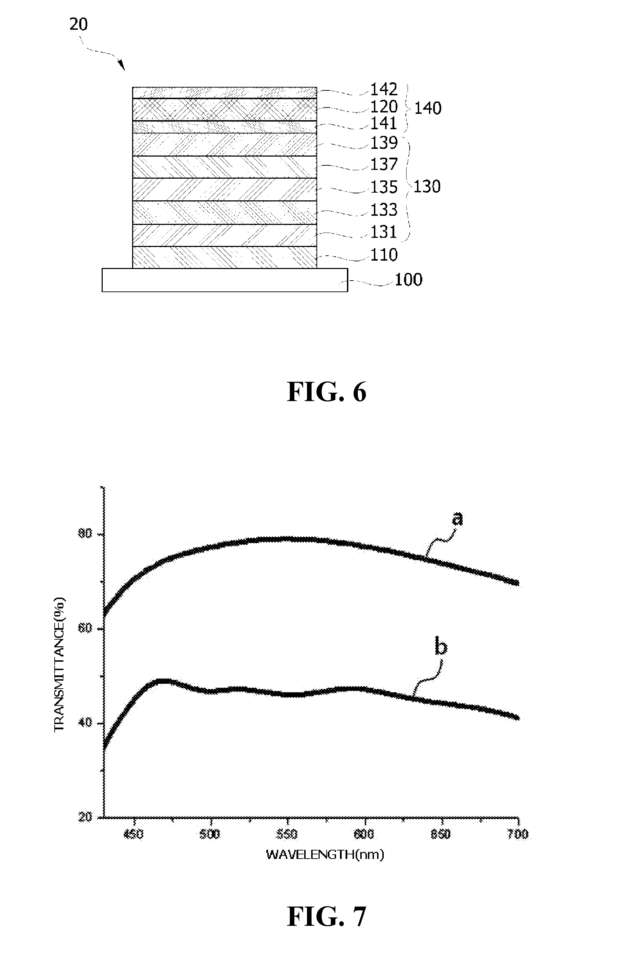

The TOLED panel 20 is manufactured by coating the upper surface of a transparent indium-tin-oxide (ITO) anode with a hole transporting layer, an emissive layer and an electron transporting layer and then with a transparent cathode composed of Mg-Ag (at a ratio of 5:95) and having a thickness less than 100 Å, and applying an ITO film on the cathode so that conductivity is compensated, the ITO film behaving as a protective layer and maintaining transparency. The TOLED panel 20 is specified later with reference to FIGS. 6 to 10.

Provided on the TOLED panel 20 is a driving IC 20a connected to the controller 40 which will be described later.

The TOLED panel 20 is a sub display unit (hereinafter, represented by the reference numeral "20") for displaying sub information. For example, in the case where the TOLED panel 20 is applied to a mobile communication terminal such as a mobile phone, it may display residual battery capacity, the time, date, user name and so on at lower resolution compared to the LCD panel 10.

The touch panel 30 is an input unit for generating an electrical signal in a manner using a capacitive type in which a conductive film is pressed by force occurring when an analyzer is pressed by a pen or hand and is thus brought into contact with an XY electrode pattern, thus allowing detection of a voltage difference of the XY electrode pattern. The touch panel 30 may be understood by the known art, and a detailed description thereof is omitted.

The touch panel 30 is disposed on the upper surface of the TOLED panel 20, and is electrically connected to the driving IC 10a of the LCD panel 10 and the controller 40 which will be described later.

The electrical signal generated from the touch panel 30 drives the electrodes of the LCD panel 10 through the controller 40 which executes the program.

The controller 40 is electrically connected to the LCD panel 10, the TOLED panel 20 and the touch panel 30, and senses the electrical signal of the touch panel 30 and thus selectively controls the driving of the LCD panel 10 and the TOLED panel 20. More particularly, the controller 40 applies voltage to the driving IC 10a of the LCD panel 10 so as to display main information through the LCD panel 10 when the electrical signal of the touch panel 30 is sensed, and applies voltage to the driving IC 20a of the TOLED panel 20 so as to display sub information through the TOLED panel 20 when the time that the LCD panel 10 is to be operated for is over.

In the present embodiment, the configuration in which the TOLED panel 20 is provided on the upper surface of the LCD panel 10 is illustrated, but the present invention is not limited thereto, and e-paper (not shown) or the like which is known in the art may be applied in lieu of the LCD panel 10.

Though not shown in the drawings, a mobile device including a PMP or a mobile communication terminal such as a mobile phone includes the above display device which includes the LCD panel 10 or e-paper and the TOLED panel 20 applied on the LCD panel 10 or e-paper so that main information such as letters, numbers, icons or video images having high resolution is displayed through the LCD panel 10 or e-paper and sub information such as residual battery capacity, the time, date, user name or the like having low resolution is displayed through the TOLED panel 20. Thus, the need for space to mount an additional sub display is obviated, and thus the structure of the mobile phone terminal can be made slim and compact.

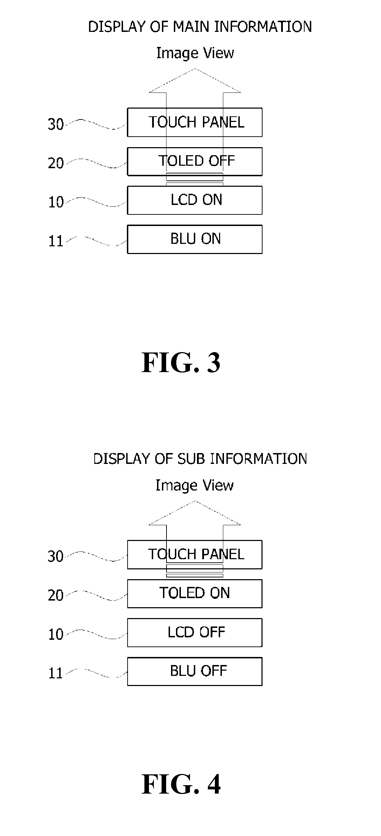

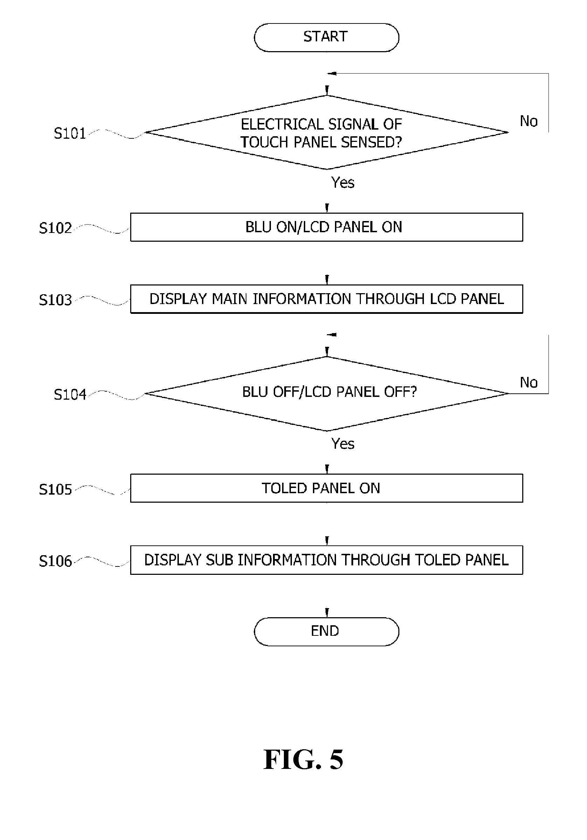

FIG. 3 illustrates the display of the main information through the LCD panel of the display device, and FIG. 4 illustrates the display of the sub information through the TOLED panel of the display device. FIG. 5 is a flowchart showing a process of controlling the display device according to the present invention which is for displaying main information and sub information.

As shown in FIGS. 3, 4 and 5, when a user presses the touch panel 30, the touch panel 30 generates an electrical signal, and the controller 40 senses whether the electrical signal of the touch panel 30 is generated (S101). More particularly, the touch panel 30 generates an electrical signal in a manner using a capacitive type in which a conductive film is pressed by force occurring when an analyzer is pressed by a pen or hand and is thus brought into contact with an XY electrode pattern, thus allowing detection of a voltage difference of the XY electrode pattern. The electrical signal thus generated is sensed by the controller 40 for executing the program.

Next, when the controller 40 senses the electrical signal of the touch panel 30, it applies driving voltage to the LCD panel 10 and the BLU 11 (S102), so that main information such as letters, numbers, icons or video images having high resolution is displayed through the LCD panel 10 (S103).

Next, the controller 40 senses whether the LCD panel 10 is on/off (S104). Specifically, whether the time that the LCD panel 11 and the BLU 11 are set to operate is over is sensed.

Next, when the time that the LCD panel 10 and the BLU 11 are set to operate is over and thus the LCD panel 10 and the BLU 11 are off, the controller 40 applies driving voltage to the TOLED panel 20 (S105), so that sub information such as residual battery capacity, the time, date, user name or the like having low resolution is displayed through the TOLED panel 20 (S106).

FIG. 6 is a cross-sectional view showing the configuration of the TOLED panel of the display device according to the present invention.

As shown in FIG. 6, the TOLED panel 20 of the display device according to the present invention includes a substrate 100, a first electrode 110, a second electrode 120, an organic layer 130, and a transparent layer 140.

The substrate 100 supports the first electrode 110, the second electrode 120, the organic layer 130 and the transparent layer 140. The substrate 100 may be formed of a glass material or a plastic material, which is transparent so as to permit emitted light to pass therethrough.

The first electrode 120 is typically referred to as a bottom electrode, and is formed on the substrate 100. The first electrode 110 is an anode which is a positive electrode and is formed on the substrate 100 using sputtering, ion plating or thermal evaporation using an e-gun. As such, according to an exemplary embodiment of the present invention, the first electrode 110 may be a transparent ITO electrode, or alternatively may be a transparent indium-zinc-oxide electrode.

The second electrode 120 is typically referred to as a top electrode disposed to face the first electrode 110, and is formed on the organic layer 130. The second electrode 120 is a cathode which is a negative electrode oppositely charged to the first electrode 110 which is the positive electrode. The second electrode 120 may be formed of any one selected from among silver (Ag), aluminum (Al) and a magnesium-silver (Mg-Ag) alloy, so that it is transparent.

The organic layer 130 is disposed between the first electrode 110 and the second electrode 120, and emits light using electrical conduction between the first electrode 110 and the second electrode 120. The organic layer 130 includes a hole injection layer (HIL) 131, a hole transporting layer (HTL) 133, an emissive layer (EML) 135, an electron transporting layer (ETL) 137 and an electron injection layer (EIL) 139, in order to emit light using electrical conduction between the first electrode 110 and the second electrode 120.

The organic layer 130 may be formed between the first electrode 110 and the second electrode 120 using spin coating, thermal evaporation, spin casting, sputtering, e-beam evaporation or chemical vapor deposition (CVD).

Specifically, the hole injection layer 131 functions to inject holes from the first electrode 110, and the hole transporting layer 133 functions to transport the holes injected from the hole injection layer 131 so as to meet with electrons of the second electrode 120.

The electron injection layer 139 functions to inject electrons from the second electrode 120, and the electron transporting layer 137 functions to transport the electrons injected from the electron injection layer 139 so as to meet with the holes transported from the hole transporting layer 133 in the emissive layer 135.

The electron transporting layer 137 may be formed by doping any one selected from among a metal having low work function and a compound thereof, in order to facilitate the injection of the electrons from the second electrode 120, and may be applied regardless of whether the electron injection layer 139 is provided or not.

As such, examples of the metal having low work function may include Cs, Li, Na, K, and Ca, and examples of the compound thereof may include Li-Al, LiF, CsF, and Cs₂CO_{3.}

The emissive layer 135 is disposed between the hole transporting layer 133 and the electron transporting layer 137 and thus emits light by means of the holes from the hole transporting layer 133 and the electrons from the electron transporting layer 137. Specifically, light emission takes place by virtue of the holes and the electrons which meet and recombine with each other in the emissive layer 135, that is, at the interfaces between the hole transporting layer 133 and the electron transporting layer 137.

The transparent layer 140 may be formed at either one or both of a position between the organic layer 130 and the second electrode 120 and a position on the upper surface of the second electrode 120. For example, the transparent layer 140 may be formed on both the upper surface and the lower surface of the second electrode 120, or alternatively only on either of the lower surface and the upper surface of the second electrode 120.

In the present embodiment, the configuration in which the transparent layer 140 is formed on both of the upper and lower surfaces of the second electrode 120 is illustrated. However, the present invention is not limited thereto, and it goes without saying that the configuration in which the transparent layer is formed only on either the lower or upper surfaces ofthe second electrode 120 is able to be applied as well.

The transparent layer 140 may include a first transparent layer 141 formed between the organic layer 130 and the second electrode 120, and a second transparent layer 142 formed on the upper surface ofthe second electrode 120.

Particularly, the first transparent layer 141 may be formed between the electron injection layer 139 of the organic layer 130 and the second electrode 120, or may be formed in the electron injection layer 139 itself. Also, the second transparent layer 142 may be formed on the upper surface of the second electrode 120 opposite the surface on which the first transparent layer 141 is formed.

Herein, the transparent layer 140 plays a role in imparting the second electrode 120 with transparency and high transmittance. The transparent layer 140 is provided in the form of a thin film to thus reduce the sheet resistance of the second electrode 120, thereby preventing the performance of the TOLED panel 20 from deteriorating. The properties of the transparent layer 140 are specified with reference to FIGS. 7 to 9 after the following descriptions of an oxide, a nitride, a salt and mixtures thereof are given.

The transparent layer 140 according to the present invention may include any one selected from among an oxide, a nitride, a salt and mixtures thereof

Examples of the oxide may include MoO₃, ITO, IZO, IO, ZnO, TO, TiO₂, SiO₂, WO₃, Al₂O₃, Cr₂O₃, TeO₂, and SrO₂, and examples of the nitride may include SiN, and AlN. Also, examples of the salt may include Cs₂CO₃, LiCO₃, KCO₃, NaCO₃, LiF, CsF, and ZnSe.

When the transparent layer 140 is formed using an oxide, a nitride, a salt or a mixture thereof, it preferably exhibits superior transmittance and luminance as shown in FIGS. 7 to 9. In addition to the above materials, any material may be used so long as the second electrode 120 is transparent and has high transmittance.

As for the transparent layer 140, the first transparent layer 141 and the second transparent layer 142 may be formed of the same material, or alternatively may be formed of different materials. For example, the first transparent layer 141 may include an oxide, and the second transparent layer 142 may include a nitride, a salt or a mixture thereof Alternatively, the first transparent layer 141 may include a nitride, and the second transparent layer 142 may include an oxide, a salt or a mixture thereof. Alternatively, the first transparent layer 141 may include a salt, and the second transparent layer 142 may include an oxide, a nitride or a mixture thereof.

The thickness of the transparent layer 140 may be set in the range from 0.1 nm to less than 100 nm. The reason why the thickness of the transparent layer 140 is limited is that if the thickness of the transparent layer 140 is less than 0.1 nm, transmittance is increased but resistance may also increase proportionally thereto, undesirably deteriorating the performance ofthe TOLED panel 20.

In contrast, if the thickness of the transparent layer 140 is 100 nm or more, resistance may decrease and thus the performance of the TOLED does not deteriorate, but the transmittance is lowered in inverse proportion to the increase in the thickness of the transparent layer 140. Also, according to an exemplary embodiment of the present invention, the transparent layer 140 may be formed using thermal evaporation.

With reference to FIGS. 7 to 9, the properties of the TOLED panel 20 according to the present invention are described below.

FIG. 7 is a graph showing the transmittance of the TOLED panel 20 according to the present invention depending on whether the transparent layer 140 is provided or not. In FIG. 7, curve "a" depicts the transmittance of the TOLED panel 20 with the transparent layer 140 according to the present invention, and curve "b" depicts the transmittance of the TOLED panel 20 without the transparent layer 140, unlike the present invention.

The TOLED panel 20 according to the present invention may exhibit a transmittance of 70 ~ 99% depending on the wavelength (nm). For example, as shown in FIG. 7, the TOLED panel 20 according to the present invention may show a transmittance of about 80% at 550 nm, and the TOLED panel 20 without the transparent layer 140 may show a transmittance of about 47% at 550 nm. Thereby, the transmittance of the TOLED panel 20 with the transparent layer 140 can be seen to be 1.7 times higher than that of the TOLED panel 20 without the transparent layer 140.

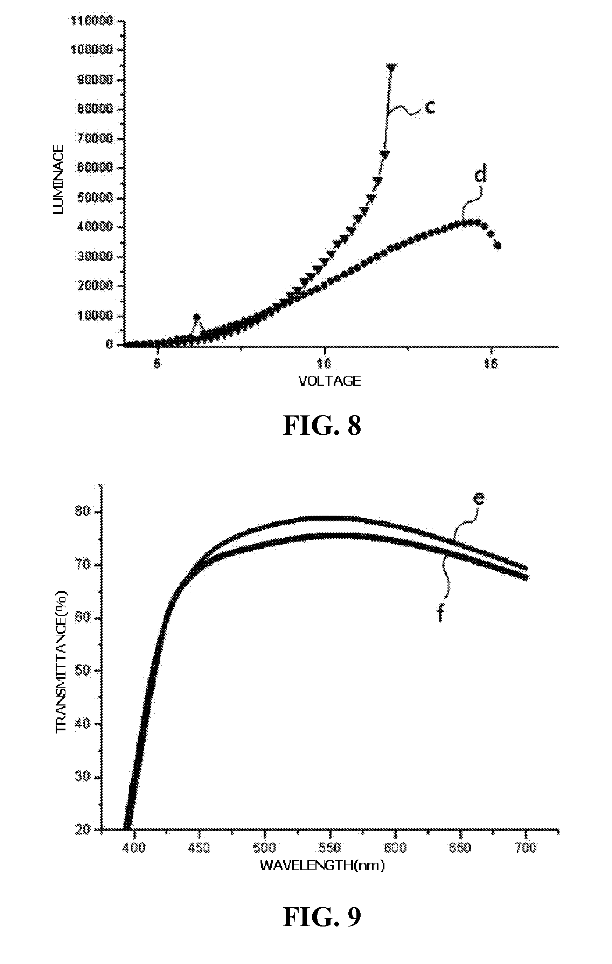

FIG. 8 is a graph showing the luminance of the TOLED panel 20 depending on whether the transparent layer 140 is provided or not. In FIG. 8, curve "c" depicts the luminance of the TOLED panel 20 with the transparent layer 140 according to the present invention, and curve "d" depicts the luminance of the TOLED panel 20 without the transparent layer 140.

The TOLED panel 20 with the transparent layer 140 manifests a luminance of about 25,000 at a voltage of 10 V, whereas the TOLED panel 20 without the transparent layer 140 shows a luminance of about 20,000 at 10 V. From this, it can be seen that there is a 1.25 times difference in the luminance depending on whether the transparent layer 140 is provided or not.

In FIG. 9, curve "e" depicts the transmittance when the transparent layer 140 is formed of an oxide such as MoO₃, ITO, IZO, IO, ZnO, TO, TiO₂, SiO₂, WO₃, Al₂O₃, Cr₂O3, TeO₂, or SrO₂, and curve "f" depicts the transmittance when the transparent layer 140 is formed of a salt such as Cs₂CO₃, LiCO₃, KCO₃, NaCO₃, LiF, CsF, or ZnSe.

As shown in FIG. 9, the transmittance is determined to be about 80% when the transparent layer 140 is formed of an oxide, and is determined to be about 75% when the transparent layer 140 is formed of a salt. Although the transmittance is about 5% higher when using the transparent layer 140 formed of an oxide than when using the transparent layer 140 formed of a salt, this is a small difference. Hence, an oxide, a salt and mixtures thereof may be selectively used as in the embodiment of the present invention.

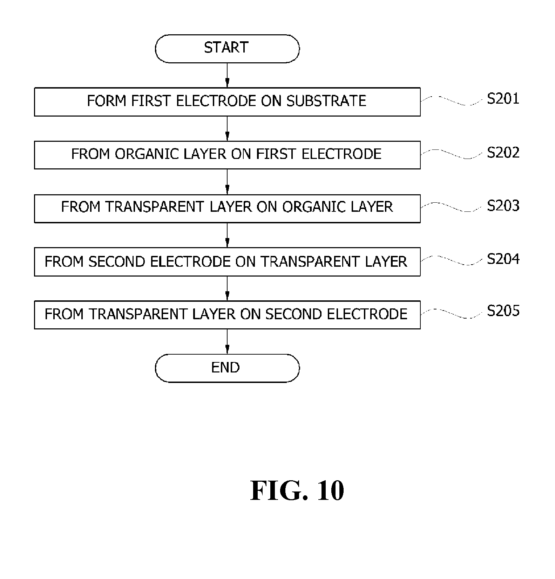

In addition, a method of manufacturing the TOLED panel 20 according to the present invention is described below with reference to FIG. 10.

First, a first electrode 110 which is a positive electrode is formed on a substrate 100 (S201).

Subsequently, an organic layer 130 is formed on the first electrode 110 which has been formed on the substrate 100 (S202). The organic layer 130 formed on the first electrode 110 includes a hole injection layer 131, a hole transporting layer 133, an emissive layer 135, an electron transporting layer 137 and an electron injection layer 139, which are sequentially formed.

Subsequently, a first transparent layer 141 is formed on the organic layer 130 (S203). According to an exemplary embodiment of the present invention, the first transparent layer 141 may include an oxide such as MoO₃, ITO, IZO, IO, ZnO, TO, TiO₂, SiO₂, WO₃, Al₂O₃, Cr₂O₃, TeO₂, or SrO₂. In consideration of resistance and transmittance, the first transparent layer 141 is formed to a thickness ranging from 0.1 nm to less than 100 nm.

Subsequently, a second electrode 120 is formed on the first transparent layer 141 (S204). The second electrode 120 which is a negative electrode may include a metal film. The metal film used as the second electrode 120 may include any one selected from among Ag, Al and an Mg-Ag alloy.

Subsequently, a second transparent layer 142 is formed on the second electrode 120 (S205). The second transparent layer 142 may include an oxide as in S203. However, the second transparent layer 142 formed on the second electrode 120 may include a nitride such as SiN or AlN, a salt such as Cs₂CO₃, LiCO₃, KCO₃, NaCO₃, LiF, CsF or ZnSe, or a mixture thereof.

When the transparent layer 140 is formed on both surfaces of the second electrode 120 in this way, double-sided light emission is possible and the transmittance may be increased.

Moreover, because of the formation of the transparent layer 140, the thickness of the second electrode 120 may be adjusted, thus increasing transmittance and electrical performance.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

### Industrial Applicability

The present invention is used to a mobile device which has a display structure displaying main and sub information using LCD or e-paper and TOLED panel.

## Claims

1. A display device, comprising:
a main display unit for displaying main information;
a sub display unit which is formed on the main display unit and which displays sub information;
a touch panel formed on the sub display unit; and
a controller which is electrically connected to the main display unit, the sub display unit and the touch panel, and which applies driving voltage to the main display unit when an electrical signal of the touch panel is sensed and applies driving voltage to the sub display unit when the main display unit is off.

2. The display device as set forth in claim 1, wherein the main display unit comprises a liquid crystal display panel or e-paper.

3. The display device as set forth in claim 1, wherein the main display unit comprises an organic light emitting diode panel.

4. The display device as set forth in claim 1, wherein the sub display unit comprises an organic light emitting diode panel.

5. The display device as set forth in claim 4, wherein the organic light emitting diode panel comprises a transparent organic light emitting diode panel.

6. The display device as set forth in claim 5, wherein the transparent organic light emitting diode panel comprises:
a substrate;
a first electrode formed on the substrate;
an organic layer formed on the first electrode;
a second electrode formed on the organic layer; and
a transparent layer formed at either one or both of a position between the organic layer and the second electrode and a position on an upper surface of the second electrode and comprising any one selected from the group consisting of an oxide, a nitride, a salt, and mixtures thereof

7. The display device as set forth in claim 6, wherein the oxide comprises any one selected from the group consisting of MoO₃, ITO, IZO, IO, ZnO, TO, TiO₂, SiO₂, WO₃, Al₂O₃, Cr₂O₃, TeO₂, and SrO₂.

8. The display device as set forth in claim 6, wherein the nitride comprises any one selected from the group consisting of SiN and AlN.

9. The display device as set forth in claim 6, wherein the salt comprises any one selected from the group consisting of Cs₂CO₃, LiCO₃, KCO₃, NaCO₃, LiF, CsF, and ZnSe.

10. The display device as set forth in claim 6, wherein the transparent layer has a thickness ranging from 0.1 nm to less than 100 nm.

11. The display device as set forth in claim 6, wherein the organic layer comprises an electron transporting layer formed by doping any one selected from the group consisting of a metal having low work function and a compound thereof, in order to facilitate injection of electrons from the second electrode.

12. The display device as set forth in claim 11, wherein the metal having low work function comprises any one selected from the group consisting of Cs, Li, Na, K, and Ca.

13. The display device as set forth in claim 11, wherein the compound thereof comprises any one selected from the group consisting of Li-Al, LiF, CsF, and Cs₂CO₃.

14. The display device as set forth in claim 6, wherein the transparent organic light emitting diode panel exhibits a transmittance of 70 ~ 99% depending on a wavelength (nm).

15. A mobile device, comprising the display device of any one of claims 1 to 14.

16. A display control method, comprising:
sensing an electrical signal of a touch panel with a controller;
applying driving voltage to a main display unit so that main information is displayed through the main display unit when the electrical signal of the touch panel is sensed;
sensing whether the main display unit is on/off with the controller; and
applying driving voltage to a sub display unit so that sub information is displayed through the sub display unit when the main display unit is off.

17. The method as set forth in claim 16, wherein the main display unit comprises a liquid crystal display panel or e-paper.

18. The method as set forth in claim 16, wherein the main display unit comprises an organic light emitting diode panel.

19. The method as set forth in claim 16, wherein the sub display unit comprises an organic light emitting diode panel.

20. The method as set forth in claim 18 or 19, wherein the organic light emitting diode panel comprises a transparent organic light emitting diode panel.
